# EUROPÄISCHE PATENTANMELDUNG

(11) **EP 4 338 814 A1**
(43) Veröffentlichungstag der Anmeldung: **20.03.2024**
(21) Anmeldenummer: 22195869.7
(22) Anmeldetag: 15.09.2022
(51) Int. Cl.: B01D 46/00, B01D 46/44, B01D 46/70, B01D 46/90, C30B 15/00

(54) **VERFAHREN UND VORRICHTUNG ZUM ENTFERNEN REAKTIVER PARTIKEL AUS EINER VAKUUMUMGEBUNG, PROZESSANLAGE ZUM HERSTELLEN MONOKRISTALLINER SILIZIUM-INGOTS**

(71) Anmelder: Flowserve Management Company, Irving, TX 75039 (US)
(72) Erfinder: HENCKE, Rayk, 25554 Nortorf (DE); MEGGERS, Nils, 25355 Barmstedt (DE); SCHREINER, Jochen, 67258 Hessheim (DE); LÄHN, Stefan, 25560 Agethorst (DE); DRECHSEL, Julian, 24235 Stein (DE)
(74) Vertreter: Glawe, Delfs, Moll

(57) **Zusammenfassung**

Verfahren zum Entfernen reaktiver Partikel aus einer Vakuumumgebung (14), bei dem mit einer Vakuumpumpe (21, 22) ein Prozessgas aus der Vakuumumgebung (14) gefördert wird. Das Prozessgas wird zwischen der Vakuumumgebung (14) und der Vakuumpumpe (21, 22) durch einen ersten Filter (31) und einen zweiten Filter (32) geleitet, um reaktive Partikel aus dem Prozessgas zu filtern. Mit einer Flüssigkeitsringpumpe (35) werden Partikel aus dem ersten Filter (31) und dem zweiten Filter (32) abgeführt. In einer ersten Phase des Verfahrens ist der erste Filter (31) aktiv und der zweite Filter (32) passiv, in einer zweiten Phase des Verfahrens ist der erste Filter (31) passiv und der zweite Filter (32) aktiv. In der ersten Phase wird das Prozessgas durch den ersten Filter (31) geleitet und die Flüssigkeitsringpumpe (35) führt Partikel aus dem zweiten Filter (32) ab. In der zweiten Phase wird das Prozessgas durch den zweiten Filter (32) geleitet und die Flüssigkeitsringpumpe (35) führt Partikel aus dem ersten Filter (31) ab. Die Erfindung betrifft weiter eine Vorrichtung zum Entfernen reaktiver Partikel aus einer Vakuumumgebung und eine Prozessanlage zum Herstellen monokristalliner Silizium-Ingots.

## Beschreibung

Die Erfindung betrifft ein Verfahren und eine Vorrichtung zum Entfernen reaktiver Partikel aus einer Vakuumumgebung. Die Erfindung betrifft auch eine Prozessanlage zum Herstellen monokristalliner Silizium-Ingots.

Ein Bedarf, reaktive Partikel aus einer Vakuumumgebung zu entfernen, besteht häufig bei Prozessanlagen, aus denen Prozessgase abgeführt werden. Ein Beispiel ist die Produktion von monokristallinen Silizium-Ingots, die aus einer Silizium-Schmelze heraus gebildet werden. Die Silizium-Schmelze ist in einem Vakuumgehäuse angeordnet, in das Argon als Spülgas eingeleitet wird. Während der Silizium-Ingot gebildet wird, besteht ein kontinuierlicher Strom des Prozessgases, indem laufend Argon in das Gehäuse eingeleitet wird und mit einer Vakuumpumpe aus dem Vakuumgehäuse abgesaugt wird.

Das Prozessgas kommt in dem Vakuumgehäuse in Kontakt mit dem Silizium-Ingot, der Silizium-Schmelze sowie mit weiteren Oberflächen und führt dadurch beim Austritt aus dem Vakuumgehäuse reaktive Partikel mit sich.

Bislang ist es üblich, die reaktiven Partikel in einem zwischen dem Vakuumgehäuse und der Vakuumpumpe angeordneten Filter zu akkumulieren, bis die Bildung des Silizium-Ingots abgeschlossen ist. Eine Phase, in der der Silizium-Ingot aus dem Vakuumgehäuse entfernt wird oder in der die Silizium-Schmelze erneuert wird, kann genutzt werden, um den Filter zu reinigen und die reaktiven Partikel zu entfernen.

Wird eine zu große Menge an reaktiven Partikeln in einem Filter akkumuliert, so können Probleme beim Reinigen der Filter auftreten. Beispielsweise können sich Staubnester bilden, die sich durch einfaches Ausblasen nicht beseitigen lassen. Weiter können durch Kontakt der reaktiven Partikel mit Sauerstoff chemische Reaktionen ausgelöst werden, bei denen Wärmeenergie freigesetzt wird. Die freigesetzte Wärmemenge kann bei einer großen Menge an reaktiven Partikeln so groß werden, dass der Filter Schaden nimmt.

Der Erfindung liegt die Aufgabe zugrunde, ein Verfahren und eine Vorrichtung zum Entfernen reaktiver Partikel aus einer Vakuumumgebung sowie eine zugehörige Prozessanlage vorzustellen, mit denen diese Nachteile vermieden werden. Die Aufgabe wird gelöst mit den Merkmalen der unabhängigen Ansprüche. Vorteilhafte Ausführungsformen sind in den Unteransprüchen angegeben.

Gegenstand der Erfindung ist ein Verfahren zum Entfernen reaktiver Partikel aus einer Vakuumumgebung, bei dem mit einer Vakuumpumpe ein Prozessgas aus der Vakuumumgebung gefördert wird und bei dem das Prozessgas zwischen der Vakuumumgebung und der Vakuumpumpe durch einen ersten Filter und einen zweiten Filter geleitet wird, um reaktive Partikel aus dem Prozessgas zu filtern. Mit einer Flüssigkeitsringpumpe werden Partikel aus dem ersten Filter und dem zweiten Filter abgeführt. In einer ersten Phase des Verfahrens ist der erste Filter aktiv und der zweite Filter passiv. In einer zweiten Phase des Verfahrens ist der erste Filter passiv und der zweite Filter aktiv. In der ersten Phase wird Prozessgas durch den ersten Filter geleitet und die Flüssigkeitsringpumpe führt Partikel aus dem zweiten Filter ab. In der zweiten Phase wird Prozessgas durch den zweiten Filter geleitet und die Flüssigkeitsringpumpe führt Partikel aus dem ersten Filter ab.

Durch die abwechselnde Verwendung von zwei parallel geschalteten Filtern zwischen der Vakuumumgebung und der Vakuumpumpe wird es möglich, den Zeitpunkt für die Reinigung der Filter unabhängig von den Vorgängen im Vakuumgehäuse festzusetzen. Während einer der Filter im aktiven Zustand ist und reaktive Partikel aus dem mit der Vakuumpumpe geförderten Prozessgas filtert, kann der andere Filter in einen passiven Zustand gebracht werden, in dem er keinen Beitrag zu den Abläufen in dem Vakuumgehäuse leistet. Im passiven Zustand können die reaktiven Partikel mit der Flüssigkeitsringpumpe aus dem Filter abgeführt werden. Durch einen wechselweisen Betrieb, in dem jeweils einer der Filter aktiv und der andere passiv ist, kann kontinuierlich Prozessgas aus der Vakuumumgebung gefördert werden, ohne dass sich in einem der Filter übermäßige Mengen reaktiver Partikel ansammeln.

Das Verfahren wird vorzugsweise so durchgeführt, dass das Prozessgas zwischen der ersten Phase und der zweiten Phase kontinuierlich aus der Vakuumumgebung gefördert wird. Zwischen der ersten Phase des Verfahrens und der zweiten Phase des Verfahrens kann es ein oder mehrere Übergangsphasen geben. Die Übergangsphase kann einen Abschnitt umfassen, in dem das Prozessgas parallel sowohl durch den ersten Filter als auch durch den zweiten Filter geleitet wird. Es kann sein, dass die Zeitdauer, die zum Abführen der Partikel aus dem passiven Filter erforderlich ist, kürzer ist als die Zeitdauer, in der mit dem aktiven Filter Prozessgas gefiltert wird. Die Übergangsphase kann dann Abschnitte umfassen, in denen der passive Filter vollkommen inaktiv ist, also weder zur Filterung des Prozessgases beiträgt noch einer Reinigung unterzogen wird.

Der erste Filter kann dazu ausgelegt sein, die reaktiven Partikel aus dem Prozessgas zu filtern, indem das Prozessgas durch ein Filtermaterial geleitet wird, an dem sich die reaktiven Partikel niederschlagen. Das Filtermaterial kann insbesondere eine poröses Material sein. Durch das Filtermaterial kann ein primärer Filterraum von einem sekundären Filterraum getrennt werden. Das von der Vakuumumgebung kommende Prozessgas kann in den primären Filterraum eingeleitet werden und durch das poröse Material hindurch in den sekundären Filterraum übertreten. Aus dem sekundären Filterraum kann das gefilterte Prozessgas mit der Vakuumpumpe abgeführt werden.

Das poröse Material kann eine rohrförmige Struktur bilden. Die Außenseite der rohrförmigen Struktur kann an den primären Filterraum angrenzen, die Innenseite der rohrförmigen Struktur kann an den sekundären Filterraum angrenzen. Die rohrförmige Struktur kann senkrecht ausgerichtet sein. Ein erstes Ende der rohrförmigen Struktur kann geschlossen sein, ein zweites Ende der rohrförmigen Struktur kann offen sein. Das zweite Ende kann mit dem sekundären Filterraum kommunizieren. Das zweite Ende kann das obere Ende der rohrförmigen Struktur sein. Der zweite Filter kann dieselben Merkmale aufweisen wie der erste Filter.

Während das Prozessgas mit dem aktiven Filter gefiltert wird, liegt in dem aktiven Filter ein Vakuum an. Nach einem Wechsel in den passiven Zustand kann in einer ersten Übergangsphase ein sauerstoffhaltiges Gas in den passiven Filter eingelassen werden, so dass der Druck in dem passiven Filter ansteigt. In einer Ausführungsform wird Umgebungsluft in den passiven Filter eingelassen, sodass der passive Filter auf Atmosphärendruck gebracht wird. Möglich ist auch, Druckluft in den passiven Filter einzulassen, deren Druck höher ist als Atmosphärendruck, oder ein Gas in den passiven Filter zu lassen, dessen Sauerstoffgehalt höher ist als der Sauerstoffgehalt von Luft. Der Filter kann zu diesem Zweck ein Lüftungsventil umfassen, das zum Einlassen des Gases geöffnet wird und das im aktiven Zustand des Filters geschlossen ist. Das Einlassen des Gases kann zu Beginn des passiven Zustands eines Filters erfolgen, also bevor die Partikel mit der Flüssigkeitsringpumpe aus dem Filter abgeführt werden.

Das Einlassen des Gases führt zu chemischen Reaktionen insbesondere zwischen den reaktiven Partikeln und Sauerstoff, bei denen Wärmeenergie freigesetzt wird. Die reaktiven Partikel verlieren ihre Reaktivität wenigstens teilweise, so dass die Gefahr von Entzündungen oder Explosionen vermindert wird.

Das sauerstoffhaltige Gas, mit dem der Innenraum des passiven Filters geflutet wird, kann in den sekundären Filterraum eingelassen werden. Auf diese Weise kann ein Gegenstrom durch das Filtermaterial hindurch erzeugt werden, der der Strömungsrichtung entgegengesetzt ist, die das Prozessgases im aktiven Zustand des Filters hat. Der Gegenstrom kann sich von dem sekundären Filterraum durch das Filtermaterial hindurch in den primären Filterraum erstrecken. Das Lüftungsventil kann schnell geöffnet werden, sodass sich eine schlagartige Strömung in den Innenraum des passiven Filters hinein einstellt. Durch den Gegenstrom werden Partikel gelöst, die sich an dem Filtermaterial abgesetzt haben. Zugleich können die reaktiven Partikel sich durch den intensiven Kontakt mit dem eintretenden Gas abreagieren, wodurch die Reaktivität der Partikel vermindert wird. Die von dem porösen Material abgelösten Partikel verteilen sich zunächst in dem primären Filterraum und sinken dann zu Boden.

Die Flüssigkeitsringpumpe kann an einen unteren Abschnitt des ersten Filters und/oder des zweiten Filters angeschlossen sein, so dass dort angesammelte Partikel mit der Flüssigkeitsringpumpe abgeführt werden können. Die Flüssigkeitsringpumpe kann an den primären Filterraum des ersten Filters und/oder des zweiten Filter angeschlossen sein. Der Boden des ersten und zweiten Filters kann als Schrägfläche ausgebildet sein, so dass die Partikel zum Anschluss der Flüssigkeitsringpumpe geleitet werden. Der Anschluss der Flüssigkeitsringpumpe kann am unteren Ende der Schrägfläche angeordnet sein. Während die Partikel aus dem passiven Filter abgeführt werden, kann ein freier Luftaustausch zwischen dem Innenraum des passiven Filters und der Umgebung bestehen, so dass das Entstehen eines Vakuums im Innenraum des passiven Filters vermieden wird.

Das Abführen der Partikel aus dem passiven Filter kann erleichtert werden, wenn die am Boden des passiven Filters angesammelten Partikel in einen fluidisierten Zustand versetzt werden. Es kann eine Fluidisiereinrichtung vorgesehen sein, mit der ein Fluidisiergasstrom in die angesammelten Partikel eingeleitet wird.

Die in Richtung der Flüssigkeitsringpumpe abgeführten Partikel vermischten sich im Inneren der Flüssigkeitsringpumpe mit der Betriebsflüssigkeit, die den Flüssigkeitsring bildet. Chemische Reaktionen zwischen den Partikeln und der Betriebsflüssigkeit können dazu beitragen, die Reaktivität der Partikel weiter zu vermindern. Die Partikel können zusammen mit der Betriebsflüssigkeit der Flüssigkeitsringpumpe aus der Flüssigkeitsringpumpe ausgeleitet werden. Die Betriebsflüssigkeit kann im Betrieb der Flüssigkeitsringpumpe ausgetauscht werden, so dass Betriebsflüssigkeit mit einem höheren Anteil an Partikeln aus der Flüssigkeitsringpumpe abgeführt wird und Betriebsflüssigkeit mit einem niedrigeren Anteil an Partikeln zu der Flüssigkeitsringpumpe zugeführt wird.

Der Austausch der Betriebsflüssigkeit kann im Betrieb der Flüssigkeitsringpumpe kontinuierlich erfolgen. Die Betriebsflüssigkeit kann Wasser sein. Es kann Frischwasser oder aufbereitetes Wasser zu der Flüssigkeitsringpumpe zugeführt werden. Möglich ist auch, die Partikel in der Betriebsflüssigkeit bis zur einer vorgegebenen Konzentration anzusammeln und die Betriebsflüssigkeit bei Erreichen der Konzentration auszutauschen.

Das Merkmal Flüssigkeitsringpumpe im Sinne der Erfindung beinhaltet keine Einschränkung hinsichtlich der Anzahl der Baueinheiten. Die erfindungsgemäße Flüssigkeitsringpumpe kann aus zwei Baueinheiten bestehen, so dass die erste Baueinheit an den ersten Filter und die zweite Baueinheit an einen zweiten Filter angeschlossen ist. Bevorzugt ist die Flüssigkeitsringpumpe als eine einzelne Baueinheit ausgeführt, die wechselweise mit dem ersten Filter und dem zweiten Filter kommuniziert.

Das mit der Flüssigkeitsringpumpe geförderte Gas kann gesammelt werden oder an die Umgebung abgeführt werden. Das Gas kann reaktive gasförmige Bestandteile wie beispielsweise Wasserstoff enthalten. Um Gefährdungen zu vermeiden, kann das Gas nach dem Austritt aus der Flüssigkeitsringpumpe verdünnt werden, zum Beispiel durch Zuführen von Luft, bis die Konzentration brennbarer Stoffe in dem Gas unterhalb der unteren Explosionsgrenze (UEG) liegt.

Im Anschluss an das Entfernen der Partikel kann der passive Filter in einer zweiten Übergangsphase für den Übergang in den aktiven Zustand vorbereitet werden. Dazu kann die Verbindung zwischen dem Innenraum des passiven Filters und der Flüssigkeitsringpumpe geschlossen werden. Ebenso kann das Lüftungsventil geschlossen werden, über das der Innenraum des passiven Filters mit der Umgebung kommuniziert. Es kann ein Vakuum in dem Innenraum des passiven Filters angelegt werden, das dem Vakuum im Innenraum des aktiven Filters entspricht. Sobald in beiden Filtern derselbe Druck anliegt, kann der bislang passive Filter in den Prozessgasstrom zwischen dem Vakuumgehäuse und der Vakuumpumpe eingeschaltet werden. Nachdem dies geschehen ist, kann der bislang aktive Filter von dem Prozessgasstrom zwischen dem Vakuumgehäuse und der Vakuumpumpe getrennt werden, so dass der bislang aktive Filter in den passiven Zustand übergeht.

Das Reinigungsintervall, also die Zeitdauer, die ein Filter im aktiven Zustand betrieben wird, kann in Abhängigkeit vom Zustand des aktiven Filters ermittelt werden. Ein Kriterium kann beispielsweise sein, dass die Druckdifferenz zwischen dem primären Filterraum und dem sekundären Filterraum einen vorgegebenen Schwellwert überschritten hat. Eine hohe Druckdifferenz kann ein Anzeichen darstellen, dass eine bestimmte Menge von reaktiven Partikeln sich in dem Filter abgesetzt hat. Zusätzlich oder alternativ dazu kann aus dem Gewicht des aktiven Filters auf eine bestimmte Menge von reaktiven Partikeln in dem aktiven Filter geschlossen werden und bei Überschreiten eines vorgegebenen Schwellwerts für das Gewicht in den passiven Zustand gewechselt werden. In einer weiteren Variante wird nach Ablauf einer vorgegebenen Zeitspanne vom aktiven Zustand in den passiven Zustand gewechselt.

Das Evakuieren des passiven Filters vor dem Übergang in den aktiven Zustand kann mit derselben Vakuumpumpe erfolgen, die auch das Vakuum für die Vakuumumgebung erzeugt. Diese Vorgehensweise kann sich negativ auf die Prozessstabilität in der Vakuumumgebung auswirken, weil es beim Evakuieren des passiven Filters zu einer Druckschwankung in der Vakuumumgebung kommen kann. In einer Ausführungsform ist deswegen eine Hilfs-Vakuumpumpe vorgesehen, mit der der passive Filter vor dem Übergang in den aktiven Zustand evakuiert wird.

Die Hilfs-Vakuumpumpe kann die weitere Funktion haben, eine Schleusenkammer zu evakuieren, über die Gegenstände in die Vakuumumgebung eingeführt werden oder aus der Vakuumumgebung entfernt werden. Die Schleusenkammer wird vor dem Übertritt von Gegenständen zwischen der Vakuumumgebung und der Schleusen, auf denselben Druck evakuiert, der in der Vakuumumgebung anliegt. Dies ist auch der Druck, auf den der passive Filter vor dem Übergang in den aktiven Zustand gebracht wird, so dass in beiden Fällen dieselben Anforderungen für die Hilfs-Vakuumpumpe gelten.

Das mit der (Haupt-)Vakuumpumpe geförderte Prozessgas kann einer Aufbereitungsstation zugeführt werden, in der das Prozessgas so aufbereitet wird, dass es zur erneuten Verwendung für den Prozess in der Vakuumumgebung geeignet ist. Insbesondere kann in der Aufbereitungsstation Argon aus dem Prozessgas regeneriert werden und zur erneuten Verwendung bereitgestellt werden. Es kann eine Verbindungsleitung zwischen der Aufbereitungsstation und der Vakuumumgebung bestehen, so dass das aufbereitete Prozessgas in Form eines geschlossenen Kreislaufs zu der Vakuumumgebung zurückgeführt wird.

Das Merkmal Vakuumpumpe im Sinne der Erfindung beinhaltet keine Einschränkung hinsichtlich der Anzahl der Baueinheiten. Die erfindungsgemäße Vakuumpumpe kann aus zwei Baueinheiten bestehen, so dass die erste Baueinheit an den ersten Filter und die zweite Baueinheit an den zweiten Filter angeschlossen ist. Bevorzugt ist die Vakuumpumpe als eine Baueinheit ausgeführt, die wechselweise mit dem ersten Filter und dem zweiten Filter kommuniziert.

In einer Ausführungsform ist die erfindungsgemäße Vakuumpumpe als Sequenz von zwei hintereinandergeschalteten Vakuumpumpen-Baueinheiten ausgestaltet. Der Eingang der zweiten Vakuumpumpen-Baueinheit kann an den Ausgang der ersten Vakuumpumpen-Baueinheit angeschlossen sein, so dass über jeder der Vakuumpumpen-Baueinheiten nur ein Teil der Druckdifferenz zwischen der Vakuumumgebung und Atmosphärendruck anliegt. Auf diese Weise kann die Energieeffizienz der Vakuumpumpe verbessert werden.

Um zu vermeiden, dass das Prozessgas durch eine Betriebsflüssigkeit oder Schmierstoffe der Vakuumpumpe verunreinigt wird, ist die Vakuumpumpe vorzugsweise als trockenlaufende Vakuumpumpe ausgebildet. In einer bevorzugten Ausführungsform ist die Vakuumpumpe eine Schraubenpumpe. Dasselbe kann für die Hilfs-Vakuumpumpe und/oder die Vakuumpumpen-Baueinheiten gelten.

Die Erfindung betrifft auch eine Vorrichtung zum Entfernen reaktiver Partikel aus einer Vakuumumgebung, mit einem Vakuumgehäuse und mit einer an das Vakuumgehäuse angeschlossenen Vakuumpumpe. Zwischen dem Vakuumgehäuse und der Vakuumpumpe sind ein erster Filter und ein zweiter Filter angeordnet, um reaktive Partikel aus einem mit der Vakuumpumpe geförderten Prozessgas zu filtern. Die Vorrichtung umfasst eine Flüssigkeitsringpumpe zum Absaugen von Partikeln aus dem ersten Filter und dem zweiten Filter. Mit einer Umschalteinrichtung wird die Vorrichtung in einen ersten Schaltzustand und einen zweiten Schaltzustand gebracht, so dass in dem ersten Schaltzustand das Prozessgas durch den ersten Filter geleitet wird und die Flüssigkeitsringpumpe Partikel aus dem zweiten Filter abführt und dass in dem zweiten Schaltzustand das Prozessgas durch den zweiten Filter geleitet wird und die Flüssigkeitsringpumpe Partikel aus dem ersten Filter absaugt.

Die Erfindung betrifft weiter eine Prozessanlage mit einem Vakuumgehäuse und einer an das Vakuumgehäuse angeschlossenen erfindungsgemäßen Vorrichtung, um reaktive Partikel aus der Vakuumumgebung des Vakuumgehäuses zu entfernen. Die Prozessanlage kann eine Schleusenkammer umfassen, um Gegenstände in das Vakuumgehäuse einzuschleusen und/oder aus dem Vakuumgehäuse auszuschleusen. Die Prozessanlage kann eine Hilfs-Vakuumpumpe umfassen, die dazu ausgelegt ist, die Schleusenkammer zu evakuieren, und die dazu ausgelegt ist, den passiven Filter vor dem Übergang in den aktiven Zustand zu evakuieren. Die Prozessanlage kann einen geschlossenen Prozessgas-Kreislauf umfassen, der sich von dem Vakuumgehäuse über die Vakuumpumpe zu einer Prozessgas-Aufbereitungsstation erstreckt und von der Prozessgas-Aufbereitungsstation zurück zu dem Vakuumgehäuse.

Die Prozessanlage kann dazu ausgelegt sein, monokristalline Silizium-Ingots herzustellen. In dem Vakuumgehäuse kann ein Schmelzofen angeordnet sein, mit dem eine Siliziumschmelze erzeugt wird. Die Schleusenkammer kann dazu ausgelegt sein, einen Siliziumkern in das Vakuumgehäuse einzuschleusen und den fertigen Silizium-Ingot aus dem Vakuumgehäuse auszuschleusen. Die Erfindung betrifft auch ein Verfahren zum Betreiben einer solchen Prozessanlage.

Von der Offenbarung umfasst sind Weiterbildungen der Vorrichtung und der Prozessanlage, die im Zusammenhang des erfindungsgemäßen Verfahrens beschrieben sind. Von der Offenbarung umfasst sind Weiterbildungen des Verfahrens, die im Zusammenhang der erfindungsgemäßen Vorrichtung oder der erfindungsgemäßen Prozessanlage beschrieben sind.

Die Erfindung wird nachfolgend unter Bezugnahme auf die beigefügten Zeichnungen anhand vorteilhafter Ausführungsformen beispielhaft beschrieben. Es zeigen:
- Fig. 1:: eine erste Ausführungsform einer erfindungsgemäßen Prozessanlage;

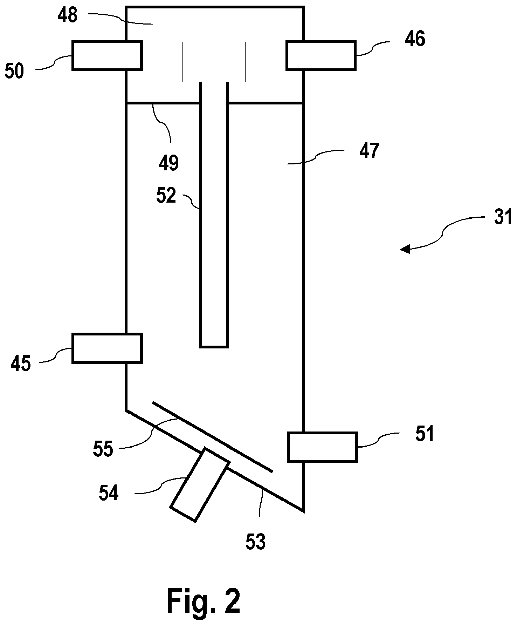

- Fig. 2:: einen Filter aus Fig. 1 in einer vergrößerten Darstellung;
- Fig. 3:: eine zweite Ausführungsform einer erfindungsgemäßen Prozessanlage.

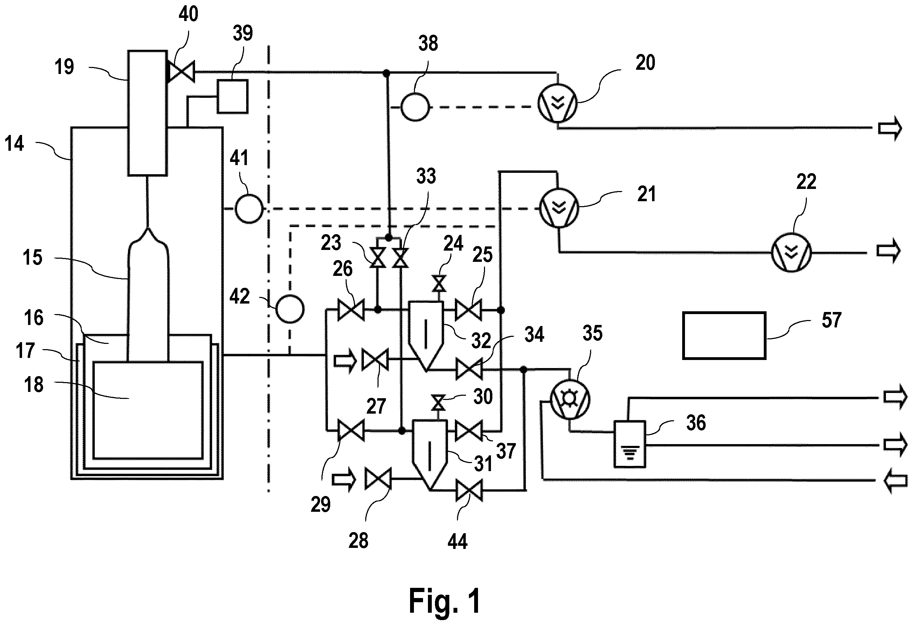

Eine in Fig. 1 gezeigte Prozessanlage umfasst ein Vakuumgehäuse 14, in dem über ein System aus einer ersten Schraubenpumpe 21 und einer zweiten Schraubenpumpe 22 ein Vakuum angelegt wird. Das System aus den Schraubenpumpen 21, 22 bildet eine Vakuumpumpe im Sinne der Erfindung. Die Schraubenpumpe 21 erhält von einem ersten Drucksensor 41 eine Information über den Druck in dem Vakuumgehäuse 14, sodass in einem geregelten Betrieb ein vorgegebener Druck in dem Vakuumgehäuse 14 erzeugt werden kann. In dem Vakuumgehäuse 14 ist ein Tiegel 16 aus einem Keramikmaterial angeordnet, der nach oben hin geöffnet ist. Der Tiegel 16 ist mit einer Heizeinrichtung 17 umgeben, so dass in dem Tiegel 16 eine Silikon-Schmelze 18 bereitgestellt werden kann.

Die Prozessanlage umfasst eine Schleusenkammer 19, in die bei Atmosphärendruck ein Silizium-Saatkristall eingebracht wird. Nach dem Schließen der Schleusenkammer 19 wird mit einer dritten Vakuumpumpe 20 wird ein Vakuum in der Schleusenkammer 19 erzeugt. Die dritte Vakuumpumpe 20, die eine Hilfs-Vakuumpumpe im Sinne der Erfindung bildet, erhält von einem zweiten Drucksensor 38 einer Information über den Druck in der Schleusenkammer 19, sodass in einem geregelten Betrieb ein vorgegebener Druck in der Schleusenkammer 19 erzeugt werden kann. Sobald der Druck in der Schleusenkammer 19 mit dem Druck in dem Vakuumgehäuse 14 übereinstimmt, wird die Schleusenkammer 19 zu dem Vakuumgehäuse 14 hin geöffnet. Der Saatkristall wird an einem Drahtseil herabgelassen, bis der Saatkristall mit der Oberfläche der Schmelze 18 in Berührung kommt. Bei langsamem Zurückziehen des Drahtseils setzt sich Siliziummaterial aus der Schmelze 18 an dem Saatkristall ab, sodass ein Silizium-Ingot 15 entsteht. Der fertige Silizium-Ingot wird in die Schleusenkammer 19 überführt. Die Schleusenkammer 19 wird von dem Vakuumgehäuse 14 getrennt, das Ventil 40 wird geschlossen und die Schleusenkammer 19 wird wieder auf Atmosphärendruck gebracht, sodass der Silizium-Ingot 15 entnommen werden kann.

Aus einem Argon-Vorrat 39 wird kontinuierlich Argon als Prozessgas in das Vakuumgehäuse 14 eingelassen. Das Argon wirkt als Spülgas, durch das störende Partikel und sonstige Bestandteile der Atmosphäre aus dem Vakuumgehäuse 14 abgeführt werden. Störende Partikel entstehen beispielsweise in Form von Siliziumoxiden, wenn es aus der Schmelze heraus zu Reaktionen mit Sauerstoff kommt. Die Anwesenheit von Sauerstoff in der Vakuumatmosphäre kann, beispielsweise aufgrund von Ausgasungen aus Komponenten in dem Vakuumgehäuse 14, nicht vollständig unterbunden werden.

In der Schmelze können Materialien für eine Dotierung des Silizium-Ingots enthalten sein. Im Falle von N-dotierten Einkristallen beispielsweise kommt roter Phosphor als Dotierungsmaterial in Betracht. Aus rotem Phosphor können sich hochreaktive Stäube bilden, die die Bildung des Silizium-Ingots stören können.

Durch den Strom des Argon-Spülgases, der durch die Schraubenpumpen 21, 22 in Gang gehalten wird, werden die reaktiven Partikel aufgenommen und aus dem Vakuumgehäuse 14 abgeführt. Mit der erfindungsgemäßen Vorrichtung wird das angereicherte Argon-Spülgas von den reaktiven Partikeln befreit, bevor das Argon-Spülgas zu der ersten Schraubenpumpe 21 gelangt.

Zu diesem Zweck sind zwischen dem Vakuumgehäuse 14 und der ersten Schraubenpumpe 21 ein erster Filter 31 und ein zweiter Filter 32 angeordnet. Die Filter 31, 32 sind parallel zueinander, sodass das Prozessgas entweder durch den ersten Filter 31 oder durch den zweiten Filter 32 hindurchtreten kann. Damit wird die Möglichkeit eröffnet, einen der beiden Filter 31, 32 in einen passiven Zustand zu bringen, in dem der jeweilige Filter gereinigt werden kann. Mit einer Steuereinheit 57 werden Ventile 23, 24, 25, 26, 27, 28, 29, 30, 33, 34, 44 angesteuert, sodass diese jeweils den gewünschten Zustand annehmen. Die Steuereinheit 57 bildet eine Umschalteinrichtung im Sinne der Erfindung.

In einer ersten Phase eines Betriebszyklus ist der erste Filter 31 aktiv und der zweite Filter 32 passiv. Die Ventile 27, 37 sind geöffnet, während die Ventile 28, 30, 44, 33 geschlossen sind, sodass das Prozessgas ausgehend von der Vakuumkammer 14 durch den ersten Filter 31 hindurch zu der ersten Schraubenpumpe 21 strömen kann. Die Ventile 25, 26 sind geschlossen, sodass durch den zweiten Filter 32 hindurch kein Prozessgas strömen kann.

Der erste Filter 31 hat ein Edelstahl-Gehäuse, innerhalb dessen eine Trennwand 49 ausgebildet ist, mit der ein primärer Filterraum 47 von einem sekundären Filterraum 48 getrennt ist. In dem primären Filterraum 47 ist eine Eingangsöffnung 45 ausgebildet, die mit dem Vakuumgehäuse 14 kommuniziert. In dem sekundären Filterraum 48 ist eine Ausgangsöffnung 46 ausgebildet, die mit der ersten Schraubenpumpe 21 kommuniziert. Zwischen dem primären Filterraum 47 und dem sekundären Filterraum 48 tritt das Prozessgas durch eine aus einem porösen Material bestehende Filterkerze 52 hindurch. Die in dem angereicherten Prozessgas enthaltenen reaktiven Partikel setzen sich an der Außenseite der Filterkerze 52 und in den Poren ab, sodass das in den Innenraum der Filterkerze 52 eintretende Prozessgas von den reaktiven Partikeln befreit ist. Das gereinigte Prozessgas tritt über den sekundären Filterraum 48 aus dem ersten Filter 31 aus und wird zu der ersten Schraubenpumpe 21 geleitet. Da das Prozessgas von reaktiven Bestandteilen befreit ist, kann es am Ausgang der zweiten Schraubenpumpe 22 gefahrlos an die Umgebung abgegeben werden. Mit der Zeit setzen sich immer mehr Partikel an der Filterkerze 52 ab, was zur Folge hat, dass der Filter in regelmäßigen Abständen einer Reinigung unterzogen werden muss, mit der die Partikel aus dem Filter entfernt werden.

Der zweite Filter 32 ist genauso aufgebaut wie der erste Filter 31. Nach einer Phase im aktiven Zustand ist der zweite Filter 32 in den passiven Zustand gebracht worden, um die Reinigung durchzuführen. Nach dem Schließen der Ventile 25, 26 gibt es keinen Fluss von Prozessgas mehr zwischen der Eingangsöffnung 45 und der Ausgangsöffnung 46. In einem ersten Schritt wird das Lüftungsventil 24 geöffnet, sodass durch eine Zuluftöffnung 50 Luft aus der Atmosphäre in den sekundären Filterraum 48 eintritt. Alternativ kann an das Lüftungsventil 24 auch eine Druckluftquelle oder ein Sauerstoffvorrat angeschlossen sein. Aufgrund der Druckdifferenz zwischen Atmosphärendruck und dem Druck im Innenraum des zweiten Filters 32 ergibt sich eine starke Strömung von dem sekundären Filterraum 48 in den primären Filterraum 47, der in Form eines Gegenstroms durch die Filterkerze 52 hindurchtritt. An der Filterkerze 52 anhaftende Partikel werden gelöst und verteilen sich zunächst mit dem Luftstrom im primären Filterraum 47, bevor sie zu Boden sinken.

Durch Kontakt mit dem Luft-Sauerstoff reagieren sich die Partikel ab, wodurch Wärme freigesetzt wird. Die Reinigungszyklen werden so gesetzt, dass die abgegebene Wärme nicht groß genug ist, um den zweiten Filter 32 zu beschädigen. Parallel zu dem als Schrägfläche 53 ausgebildeten Boden des zweiten Filters 32 ist ein Gitterrost 55 angeordnet. Mit einer an das Ventil 27 angeschlossenen Fluidisiereinrichtung wird ein Luftstrom durch eine Fluidisieröffnung 54 in den zweiten Filter 32 eingeleitet, der sich zwischen der Schrägfläche 53 und dem Gitterrost 55 verteilt und von unten durch das Gitterrost hindurchtritt. Durch den Luftstrom werden die sich am Boden des zweiten Filters 32 sammelnden Partikel in einen fluidisierten Zustand versetzt.

Die fluidisierten Partikel werden mit einer Flüssigkeitsringpumpe 35 durch eine Reinigungsöffnung 51 hindurch aus dem zweiten Filter 32 abgesaugt. Die Phase, in der die Flüssigkeitsringpumpe 35 in Betrieb ist, um Partikel aus dem zweiten Filter 32 abzuführen, ist die erste Phase eines Betriebszyklus im Sinne der Erfindung. Eine vorherige Phase wird als erste Übergangsphase bezeichnet, eine an die erste Phase anschließende Phase wird als zweite Übergangsphase bezeichnet.

Der Flüssigkeitsringpumpe 35 wird im Betrieb laufend Frischwasser als Betriebsflüssigkeit zugeführt. Eine entsprechende Menge an Betriebsflüssigkeit wird über den Ausgang der Flüssigkeitsringpumpe 35 abgeführt und zu einem Sammelbehälter 36 gefördert. Die aus dem zweiten Filter 32 abgeführten Partikel vermischen sich mit der Betriebsflüssigkeit und gelangen zusammen mit der Betriebsflüssigkeit in den Sammelbehälter 36. Partikel, die ihre Reaktivität bis dahin noch nicht vollständig verloren haben, können sich durch Kontakt mit der Betriebsflüssigkeit weiter abreagieren. Gasförmige Bestandteile werden nach oben aus dem Sammelbehälter 36 abgeführt. Falls reaktive gasförmige Bestandteile enthalten sind, kann das abgeführte Gas mit Luft verdünnt werden, bevor es in die Umgebung entlassen wird. Die mit den Partikeln angereicherte Betriebsflüssigkeit wird ebenfalls aus dem Sammelbehälter 36 entnommen und einer Aufbereitung zugeführt.

Nachdem die Partikel aus dem zweiten Filter 32 entfernt sind, werden die Ventile 24, 27, 34 wieder geschlossen und der zweite Filter 32 in einer zweiten Übergangsphase für den Übergang in den aktiven Zustand vorbereitet. Dazu wird zunächst das Ventil 23 geöffnet, sodass der Innenraum des zweiten Filters 32 durch die dritte Vakuumpumpe 20 evakuiert wird. Sobald der Druck im Innenraum des zweiten Filters 32 mit dem Druck im Innenraum des ersten Filters 31 übereinstimmt, ist der zweite Filter 32 bereit für den Übergang in den aktiven Zustand und das Ventil 23 wird wieder geschlossen.

Mit einem Drucksensor wird die Druckdifferenz zwischen der Eingangsöffnung 45 und der Ausgangsöffnung 46 des ersten Filters 31 überwacht. Je mehr Partikel sich in dem ersten Filter 31 ansammeln, desto größer wird die Druckdifferenz, sodass ein Schwellwert für die Druckdifferenz festgelegt werden kann, bei dessen Erreichen eine Reinigung des ersten Filters 31 erforderlich ist. Ist der Schwellwert erreicht, werden die Ventile 25, 26 geöffnet, sodass der zweite Filter 32 in den aktiven Zustand übergeht. Die Ventile 29, 37 werden geschlossen, um den ersten Filter 31 in den passiven Zustand zu bringen.

Die Reinigung des ersten Filters 31 beginnt wie beschrieben mit dem Öffnen des Ventils 30, sodass Luft aus der Umgebung in den sekundären Filterraum 48 eintritt. Nach Aktivieren einer an das Ventil 28 angeschlossenen Fluidisiereinrichtung und Öffnen des Ventils 44 ist der erste Filter 31 mit der Flüssigkeitsringpumpe 35 verbunden, sodass die Partikel abgesaugt werden können. Anschließend werden die Ventile 28, 30, 44 geschlossen und das Ventil 33 geöffnet, um den Innenraum des ersten Filters 31 zu evakuieren, sodass der erste Filter 31 bereit für einen erneuten Übergang in den aktiven Zustand ist. Das Betätigen der jeweiligen Ventile erfolgt gedämpft, um die Auswirkungen auf den Druck des Prozessgases so gering wie möglich zu halten. Davon ausgenommen sind die Lüftungsventile 24, 30, die schnell geöffnet werden, um eine möglichst schlagartige Strömung in den Innenraum der Filter 31, 32 zu erzeugen.

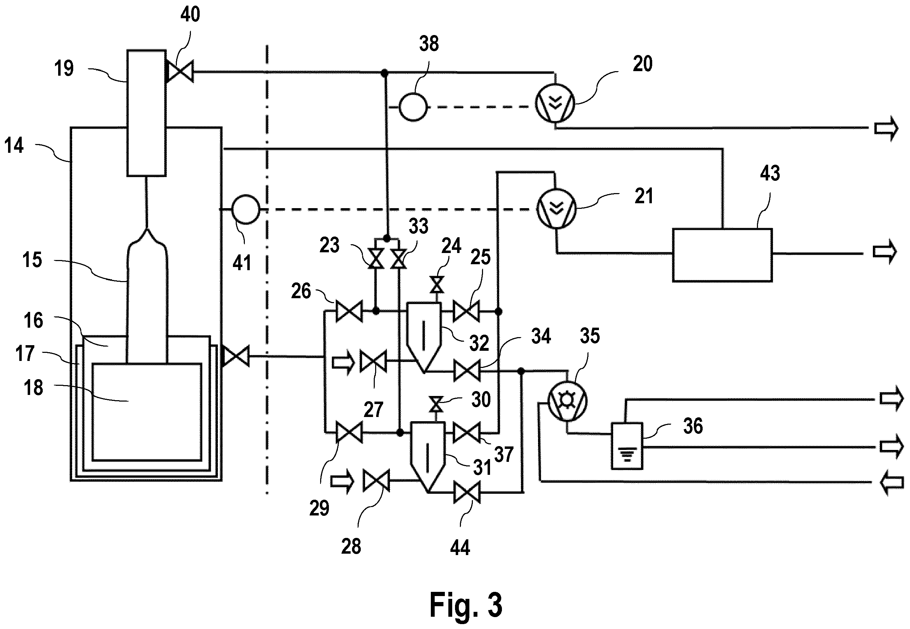

Bei der alternativen Ausführungsform gemäß Fig. 3 ist die Vakuumpumpe, mit der das Vakuum in dem Vakuumgehäuse 14 erzeugt wird, eine einzelne Schraubenpumpe 21. An den Ausgang der Schraubenpumpe 21 ist eine Aufbereitungsvorrichtung 43 angeschlossen, in der das aus dem Vakuumgehäuse 14 geförderte und von reaktiven Partikeln befreite Prozessgas aufbereitet wird. Das aus der Aufbereitung entstehende reine Argon wird zu dem Vakuumgehäuse 14 zurückgeführt und kann dort erneut als Spülgas wirken. Andere Bestandteile des Prozessgases werden an die Umgebung abgegeben.

Die Reinigungsintervalle werden nicht anhand des Differenzdrucks über den Filtern 31, 32 ermittelt, sondern nach Zeitdauer. Ist das Prozessgas für eine vorgegebene Zeitspanne durch den aktiven Filter hindurchgetreten, so wird angenommen, dass eine ausreichende Menge an Partikeln sich angesammelt hat, sodass eine Reinigung fällig ist.

## Patentansprüche

1. Verfahren zum Entfernen reaktiver Partikel aus einer Vakuumumgebung (14), bei dem mit einer Vakuumpumpe (21, 22) ein Prozessgas aus der Vakuumumgebung (14) gefördert wird, bei dem das Prozessgas zwischen der Vakuumumgebung (14) und der Vakuumpumpe (21, 22) durch einen ersten Filter (31) und einen zweiten Filter (32) geleitet wird, um reaktive Partikel aus dem Prozessgas zu filtern, und bei dem mit einer Flüssigkeitsringpumpe (35) Partikel aus dem ersten Filter (31) und dem zweiten Filter (32) abgeführt werden, wobei in einer ersten Phase des Verfahrens der erste Filter (31) aktiv ist und der zweite Filter (32) passiv ist, wobei in einer zweiten Phase des Verfahrens der erste Filter (31) passiv ist und der zweite Filter (32) aktiv ist, wobei in der ersten Phase das Prozessgas durch den ersten Filter (31) geleitet wird und die Flüssigkeitsringpumpe (35) Partikel aus dem zweiten Filter (32) abführt, und wobei in der zweiten Phase das Prozessgas durch den zweiten Filter (32) geleitet wird und die Flüssigkeitsringpumpe (35) Partikel aus dem ersten Filter (31) abführt.

2. Verfahren nach Anspruch 1, wobei zwischen der ersten Phase und der zweiten Phase kontinuierlich Prozessgas aus der Vakuumumgebung (14) gefördert wird.

3. Verfahren nach Anspruch 1 oder 2, wobei der erste Filter (31) und/oder der zweite Filter (32) einen primären Filterraum (47) und einen sekundären Filterraum (48) umfassen, die durch ein Filtermaterial (52) voneinander getrennt sind, und wobei das Prozessgas vom primären Filterraum (47) durch das Filtermaterial (52) hindurch in den sekundären Filterraum (48) übertritt.

4. Verfahren nach einem der Ansprüche 1 bis 3, wobei in einer ersten Übergangsphase ein sauerstoffhaltiges Gas in den passiven Filter (31, 32) eingelassen wird.

5. Verfahren nach Anspruch 4, wobei das sauerstoffhaltige Gas in den sekundären Filterraum (48) eingelassen wird, sodass ein Gegenstrom durch das Filtermaterial (25) hindurch entsteht.

6. Verfahren nach Anspruch 4 oder 5, wobei die Flüssigkeitsringpumpe (35) an den primären Filterraum (47) des ersten Filters (32) und/oder des zweiten Filters (32) angeschlossen ist.

7. Verfahren nach einem der Ansprüche 1 bis 6, wobei die aus dem passiven Filter (31, 32) abgeführten Partikel zusammen mit einer Betriebsflüssigkeit der Flüssigkeitsringpumpe (35) aus der Flüssigkeitsringpumpe ausgeleitet werden.

8. Verfahren nach einem der Ansprüche 1 bis 7, wobei das aus der Vakuumpumpe (21, 22) austretende Prozessgas zur erneuten Verwendung in der Vakuumumgebung (14) aufbereitet wird.

9. Verfahren nach Anspruch 8, wobei Argon aus dem Prozessgas regeneriert wird.

10. Vorrichtung zum Entfernen reaktiver Partikel aus einer Vakuumumgebung, mit einem Vakuumgehäuse (14) und mit einer an das Vakuumgehäuse (14) angeschlossenen Vakuumpumpe (21, 22), wobei zwischen dem Vakuumgehäuse (14) und der Vakuumpumpe (21, 22) ein erster Filter (31) und ein zweiter Filter (32) angeordnet sind, um reaktive Partikel aus einem mit der Vakuumpumpe (21, 22) geförderten Prozessgas zu filtern, mit einer Flüssigkeitsringpumpe (35) zum Absaugen von Partikeln aus dem ersten Filter (31) und dem zweiten Filter (32), und mit einer Umschalteinrichtung (57), um die Vorrichtung in einen ersten Schaltzustand und einen zweiten Schaltzustand zu bringen, sodass in dem ersten Schaltzustand das Prozessgas durch den ersten Filter (31) geleitet wird und die Flüssigkeitsringpumpe (35) Partikel aus dem zweiten Filter (32) abführt und dass in dem zweiten Schaltzustand das Prozessgas durch den zweiten Filter (32) geleitet wird und die Flüssigkeitsringpumpe (35) Partikel aus dem ersten Filter (31) absaugt.

11. Prozessanlage, umfassend eine Vorrichtung nach Anspruch 10, wobei in dem Vakuumgehäuse (14) monokristalline Silizium-Ingots hergestellt werden und wobei von der Vakuumpumpe (21, 22) abgegebenes Prozessgas aufbereitet wird und zu dem Vakuumgehäuse (14) zurückgeführt wird.
